(19) Europäisches Patentamt

European Patent Office

Office européen des brevets

(11) **EP 0 868 753 B1**

(12) **EUROPÄISCHE PATENTSCHRIFT**

(45) Veröffentlichungstag und Bekanntmachung des Hinweises auf die Patenterteilung:
**12.04.2000 Patentblatt 2000/15**

(21) Anmeldenummer: **96946217.5**

(22) Anmeldetag: **18.12.1996**

(51) Int Cl.⁷: **H01L 39/24**

(86) Internationale Anmeldenummer:
**PCT/DE96/02475**

(87) Internationale Veröffentlichungsnummer:
**WO 97/23896 (03.07.1997 Gazette 1997/29)**

(54) **SCHICHTENFOLGE MIT WENIGSTENS EINEM EPITAKTISCHEN, NICHT C-ACHSEN ORIENTIERTEN HTSL-DÜNNFILM ODER MIT EINER SCHICHT AUS EINER MIT HTSL KRISTALLOGRAPHISCH VERGLEICHBAREN STRUKTUR**

LAYER SEQUENCE WITH AT LEAST ONE EPITAXIAL, NON-C-AXIS ORIENTED HTSC THIN FILM OR WITH A LAYER OF A STRUCTURE CRYSTALLOGRAPHICALLY COMPARABLE TO HTSC

SUCCESSION DE COUCHES COMPORTANT AU MOINS UNE COUCHE MINCE EPITAXIALE A SUPRACONDUCTEURS HAUTE TEMPERATURE NON ORIENTEE SELON L'AXE C OU UNE COUCHE DE STRUCTURE COMPARABLE SUR LE PLAN CRISTALLOGRAPHIQUE A DES SUPRACONDUCTEURS HAUTE TEMPERATURE

(84) Benannte Vertragsstaaten:
**DE FR GB**

(30) Priorität: **22.12.1995 DE 19549291**
**21.11.1996 DE 19648234**

(43) Veröffentlichungstag der Anmeldung:
**07.10.1998 Patentblatt 1998/41**

(73) Patentinhaber: **FORSCHUNGSZENTRUM JÜLICH GMBH**
**52425 Jülich (DE)**

(72) Erfinder:
• **DIVIN, Yuri**
**D-52428 Jülich (DE)**
• **SEO, Jin-Won**
**D-52072 Aachen (DE)**

• **POPPE, Ulrich**
**D-52349 Düren (DE)**

(56) Entgegenhaltungen:
• **PATENT ABSTRACTS OF JAPAN vol. 016, no. 029 (C-0904), 24.Januar 1992 & JP 03 242320 A (NIPPON TELEGR & TELEPH CORP), 29.Oktober 1991,**
• **PHYSICA C, 1 JUNE 1995, NETHERLANDS, Bd. 247, Nr. 3-4, ISSN 0921-4534, Seiten 309-318, XP002033416 POELDERS S ET AL: "Transition from (110) to (103)/(013) growth in YBa2Cu3O7-x thin films on (110) SrTiO3 substrates"**
• **PHYSICAL REVIEW B (CONDENSED MATTER), 1 NOV. 1992, USA, Bd. 46, Nr. 18, ISSN 0163-1829, Seiten 11902-11913, XP000676226 EOM C B ET AL: "Growth mechanisms and properties of 90 degrees grain boundaries in YBa2Cu3O7 thin films" in der Anmeldung erwähnt**

## Beschreibung

Die Erfindung betrifft eine Schichtenfolge mit wenigstens einem epitaktischen, nicht c-Achsen orientierten, insbesondere nahezu a-Achsen oder b-Achsen orientierten HTSL-Dünnfilm oder mit einer Schicht aus einer mit HTSL kristallographisch vergleichbaren Struktur.

Die Erfindung betrifft vor allem Schichtenfolgen für Bauelemente im Bereich der Supraleitungselektronik und vor allem die Herstellung von epitaktischen Dünnfilmen aus oxidkeramischen Hochtemperatursupraleitern sowie Materialien mit ähnlicher kristallographischer Struktur, welche zusammen mit Hochtemperatursupraleitern in epitaktischen Multilagensystemen benutzt werden können. Diese Materialien besitzen eine Schichtstruktur mit stark anisotropen Eigenschaften.

In den Hochtemperatursupraleitern enthalten die Schichten planare Baugruppen, welche stark gebundene $CuO_2$-Ebenen enthalten. Diese Ebenen bestimmen im wesentlichen auch die Gitterkonstanten a und b innerhalb der Schichtebenen (für HTSL gilt a ≈ b ≈ 3.9 Å). Die Schichtstruktur bewirkt z.B. eine hohe kritische Stromdichte und eine verhältnismäßig große Kohärenzlänge in den Schichtebenen sowie einen kleinen kritischen Strom senkrecht zur Schichtebene entlang der kristallographischen c-Achse.

Zur Herstellung von beispielsweise Bauelementen mit planaren HTSL-Josephsonkontakten wäre es erwünscht, sehr viel einfacher solche dafür erforderlichen Schichtenfolgen herzustellen und wenn dabei die gut leitenden a,b-Ebenen der Josephsonkontaktelektroden einen Zugang zur Filmoberfläche (bzw. zur späteren inneren Grenzfläche des Josephsonkontaktes) besitzen würden.

Weiterhin ist es wichtig hierbei epitaktische Dünnfilme aus einheitlich orientierten Domänen bereitzustellen, welche Korngrenzen vermeiden. Korngrenzen zwischen verschieden orientierten Domänen stellen unerwünschte, geschwächte supraleitende Bereiche dar, welche die Funktion des Bauelementes stören.

Die epitaktischen HTSL-Dünnfilme werden in der Regel auf (bevorzugt perowskitartigen) Substraten mit kubischer oder pseudokubischer (d.h. leicht aus der kubischen Struktur verzerrt) Kristallstruktur mit möglichst guter Anpassung der Gitterkonstanten ($a_{Substrat}$ ≈ $a_{Film}$ ≈ $b_{Film}$) aufgewachsen.

Typischerweise beträgt die Gitterfehlpassung

$$\frac{a_{substrat} - a_{film}}{a_{substrat}}$$

weniger als einige Prozent.

Auf (001)-orientierten Substraten werden zur Zeit vor allem epitaktische HTSL-Dünnfilme mit den Schichtebenen senkrecht zur Substratoberflächennormalen , wie in der Figur la dargestellt, die als c-Achsen orientierte Filme bezeichnet werden, bei relativ hohen Substrattemperaturen deponiert. Dies hat seine Begründung darin, daß in der Regel nur diese die für Anwendungen notwendigen Eigenschaften, wie etwa hohe Stromtragfähigkeit, besitzen.

Eine Orientierung mit den leitenden Ebenen senkecht zur Oberfläche erreicht man nur für relativ niedrige Substrattemperaturen. Diese sogenannten a-Achsen orientierten Filme bestehen aus Domänen mit gegenseitig senkrecht zueinander orientierter c-Achse in der Dünnfilmebene. Sowohl die niedrige Substrattemperatur als auch die entstehenden Korngrenzen zwischen den Domänen führen zur Verschlechterung der supraleitenden Eigenschaften dieser Filme, wie beispielsweise aus Journal of Appl.Phys., 70, (1991), 7167 oder auch aus Physica C 194, (1992), 430 bekannt ist.

Aus Phys.Rev.B, 46, (1992), 11902 oder auch Proceedings of European Conf. on Appl. Superconductivity(EUCAS'93), Oct.4-8, 1993, Göttingen ist bekannt, daß auch für (101)-orientierte Substrate selbst bei hohen Substrattemperaturen Dünnfilme mit (103)- bzw. ($\bar{1}$03)-orientierten Domänen aufwachsen, deren $CuO_2$-Ebenen um 45° gegenüber der Substratoberfläche verkippt sind. Diese sogenannten (103)-Filme besitzen eine sehr komplizierte Mikrostruktur mit verschiedenen Typen von 90°-Korngrenzen zwischen den beiden Domänen verschiedener Orientierung. In diesem Fall verläuft die Wachstumsfront bei der Dünnfilmdeposition nicht parallel zur (103)-Ebene, d.h. die Filmoberfläche ist sehr rauh und führt im Ergebnis dazu, daß nur ein geringer Teil der leitenden $CuO_2$-Schichtebenen die Filmoberfläche erreicht.

Weiterhin ist aus Appl.Phys.Lett., 61,(1992), 607 die Herstellung von (105)-orientierten $YBa_2Cu_3O_7$-Filmen auf (305)-Substraten bekannt, bei welchen die $CuO_2$-Ebenen um einen Winkel von 31° relativ zur Substratoberfläche verkippt sind. Die kritische Stromdichte in der Filmebene entlang der (50l)-Richtung betrug lediglich etwa $10^3$ A/cm$^2$ bei 77 K und ist daher für Anwendungen wenig geeignet. Weiterhin ist bei dem relativ geringen Verkippungswinkel der Ebene die Zahl von $CuO_2$-Ebenen pro Flächeneinheit an der Oberfläche merklich reduziert.

Es ist deshalb Aufgabe der Erfindung, eine Schichtenfolge zu schaffen sowie ein Verfahren zur Herstellung eines solchen bereitzustellen, bei dem eine Reduzierung dieser Nachteile erreicht wird.

Die Aufgabe wird gelöst durch eine Schichtenfolge gemäß der Gesamtheit der Merkmale nach Anspruch 1 oder 2.

Die Erfindung stellt eine Schichtenfolge bzw. Herstellungstechnik von epitaktischen Dünnfilmen aus Materialien mit Schichtstruktur dar, welche eine zur Substratnormalen verkippte c-Achse (Achse senkrecht zu den Schichtebenen) aufweisen und bei denen nur eine Art von Domänen mit gleicher Orientierung der c-Achsen auftritt.

Damit wird eine Schichtenfolge sowie ein Verfahren zur Herstellung einer epitaktische Materialien enthaltende Schichtenfolge mit Schichtstruktur mit quasi-rationalem Verhältnis der Gitterkonstanten innerhalb der Schichtebene (a,b) zur Gitterkonstanten senkrecht zu den Schichtebenen erhalten, bei dem die Schichtenfolge eine sehr gute Kristallqualität und eine Kristallorientierung, bei welcher eine große Zahl leitfähiger Ebenen die Filmoberfläche erreicht, aufweist.

Um epitaktische Dünnschichten von Materialien mit Schichtstruktur - insbesondere HTSL, aber auch andere insofern mit HTSL vergleichbare Materialien - mit den geforderten Eigenschaften zu erhalten, wird wie folgt vorgegangen:

Es wird zunächst angenommen, daß das Schichtmaterial angenähert ein rationales Verhältnis zwischen der Gitterkonstanten $a_{Film}$ ($\approx b_{Film}$) innerhalb der Schichtebenen und der Gitterkonstanten cFilm senkrecht zu den Ebenen besitzen: $c_{Film} \approx N \times a_{Film}$, N = 2,3,4.....

Dann wird für die Deposition ein kubisches bzw. pseudokubisches (leicht verzerrtes) Substrat mit der Gitterkonstanten asubstrat ($\approx b_{Substrat} \approx c_{Substrat}$) mit geringer Fehlpassung bezüglich des zu deponierenden Dünnfilms ($a_{Substrat} \approx a_{Film}$) in kristallographischen Orientierungen aus der Familie {10M}, wobei M = K × N und K = 1,2.... gewählt.

Der Film wird dann für K = 1 die Orientierung ($\bar{K}$01) bei der Schichtbildung annehmen. Bevorzugt soll K= 1 gewählt werden.Wenn auch für höhere Werte von K unvermeidbare Unebenheiten der Substratoberfläche Wachstumsstörungen hervorrufen können sind auch solche K-Werte brauchbar.

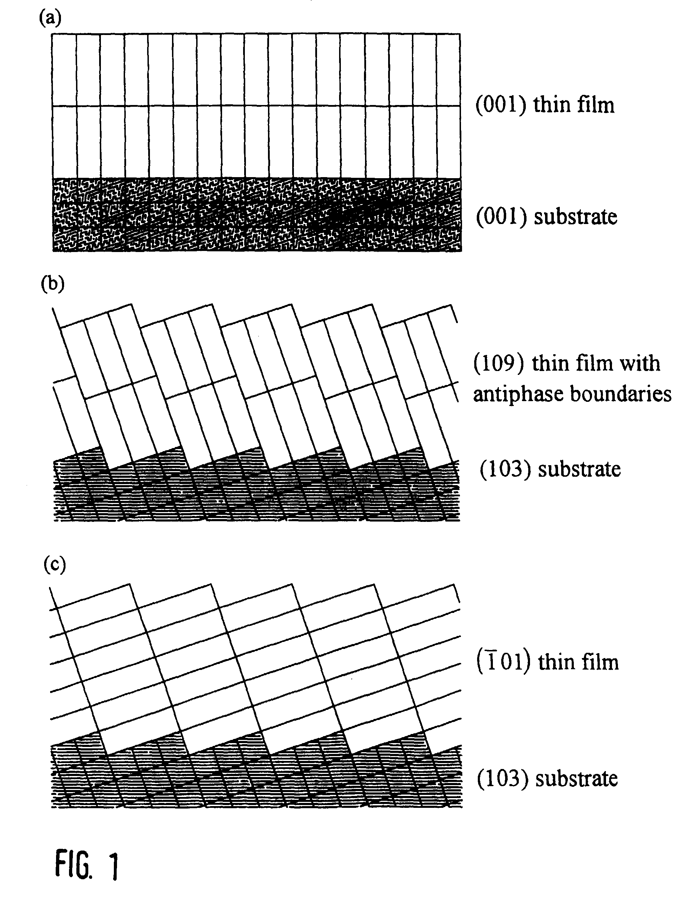

Im Fall K = 1 ist wird der größte Energieunterschied zwischen einem Film, der aus Domänen $(10N^2)$-Orientierung bzw. Antidomänen ($\bar{1}$01)-Orientierung besteht, erzielt. Wegen lokaler Grenzflächendefekte oder dessen in Figur 1b angedeuteten Antiphasengrenzen ist das Wachstum von Domänen gegenüber den ($\bar{1}$01)-orientierten Antidomänen unterdrückt. Dies liefert für den Fall K = 1 und N = 3 eine gute Mikrostruktur eines Films aus ($\bar{1}$01)-orientierten Antidomänen mit einem Verkippungswinkel der ab $(CuO_2)$-Filmebenen von etwa 72° gegenüber der Substratoberfläche (siehe Figur 1c).

Diese Vorschrift bewirkt eine gute Kristallstruktur des aufwachsenden Films mit einer einheitlichen Orientierung der Schichtebenen sowie einer starken Verkippung der Ebenen gegenüber der Substratnormalen.

Die Erfindung ist im weiteren an Hand von Figuren und Ausführungsbeispiel näher erläutert. Es zeigt:

Fig. 1:      Querschnitt eines (001)-Substrats mit (001)-Dünnfilm (Fig. 1a), eines (103)-Substrats mit (109)-Dünnfilm (Fig. 1b) sowie eines (103)-Substrats mit ($\bar{1}$01)-Dünnfilm (Fig. 1c);

Fig. 2:      Elektronenmikroskopische Aufnahme eines (103)-orientierten $NdGaO_3$-Substrats (in

pseudokubischer Notation) mit einem ($\bar{1}$01)-orientierten $YBa_2Cu_3O_7$-HTSL-Dünnfilm nach Figur 1c im Querschnitt;

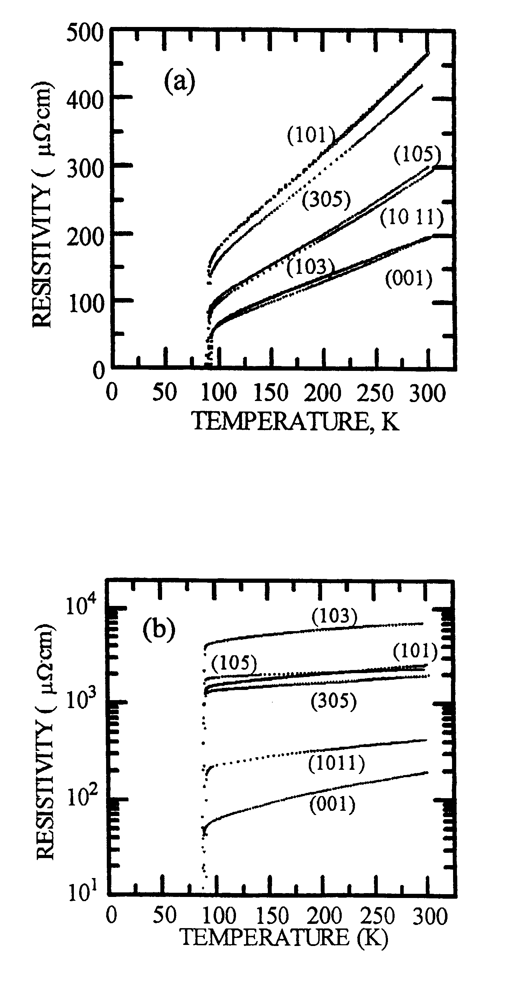

Fig. 3:      Elektrischer Widerstand in Abhängigkeit der Temperatur eines ($\bar{1}$01)-orientierten Filmes parallel (a) und senkrecht (b) zur Verkippung;

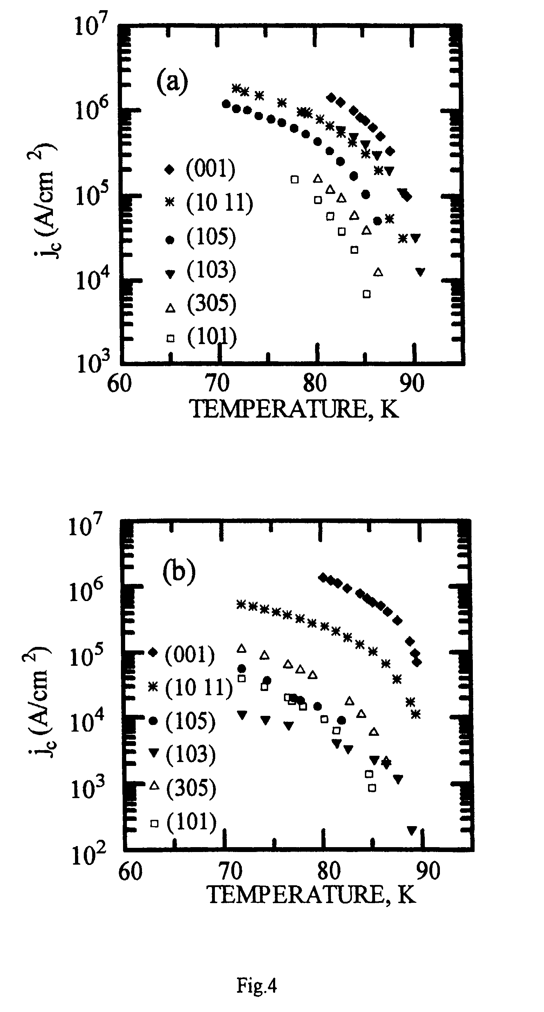

Fig. 4:      Kritische Stromdichte in Abhängigkeit der Temperatur eines ($\bar{1}$01)-orientierten Filmes parallel (a) und senkrecht (b) zur Verkippung.

Ausführungsbeispiele

Zur Verdeutlichung sollen als Beispiel zunächst die möglichen unterschiedlichen Anordnungen des Kristallgitters eines Schichtmaterials mit der Gitterkonstanten $c_{Film} \approx 3 \times a_{Film}$ auf einem kubischen Substrat mit der Gitterkonstanten $a_{Substrat} \approx a_{Film}$ und den Orientierungen (100) [Figur 1a] und (103) [Figur 1b, 1c] genauerdiskutiert werden. Ein solcher Fall liegt beispielsweise annähernd für einen $YBa_2Cu_3O_7$-Film auf einem $NdGaO_3$ Substrat, welcher experimentell untersucht wurde, vor, mit folgenden Gitterkonstanten:

$a_{NdGaO_3}^{pseudo} \approx 3.87$ Å      $^b YBa_2Cu_3O_7 \approx 3.88$ Å

$^a YBa_2Cu_3O_7 \approx 3.82$ Å      $^c YBa_2Cu_3O_7 \approx 11.7$ Å

Der Vergleich von Figur 1b und Figur 1c zeigt, daß der ($\bar{1}$01)-orientierte Film in Figur 1c im Vergleich zum (109)-orientierten Film aus Figur 1b keine Defekte wie die hier gezeigten Antiphasengrenzen aufweist und daß diese Konfiguration dabei energetisch begünstigt ist.

Daher wird das Schichtmaterial, wenn es möglichst weitgehend unter Gleichgewichtsbedingungen deponiert wird, mit der Orientierung aufwachsen, welche die Energie im aufwachsenden Film minimiert. Dies ist in diesem Beispiel für den ($\bar{1}$01)-orientierten Film in Figur lc der Fall, da ein Film mit (109)-Orientierung viele lokale Defekte (wie Antiphasengrenzen) an der Substratgrenzfläche aufweisen muß, welche zu großen Verspannungen im aufwachsenden Film, vor allem in der Nukleationsphase, führen.

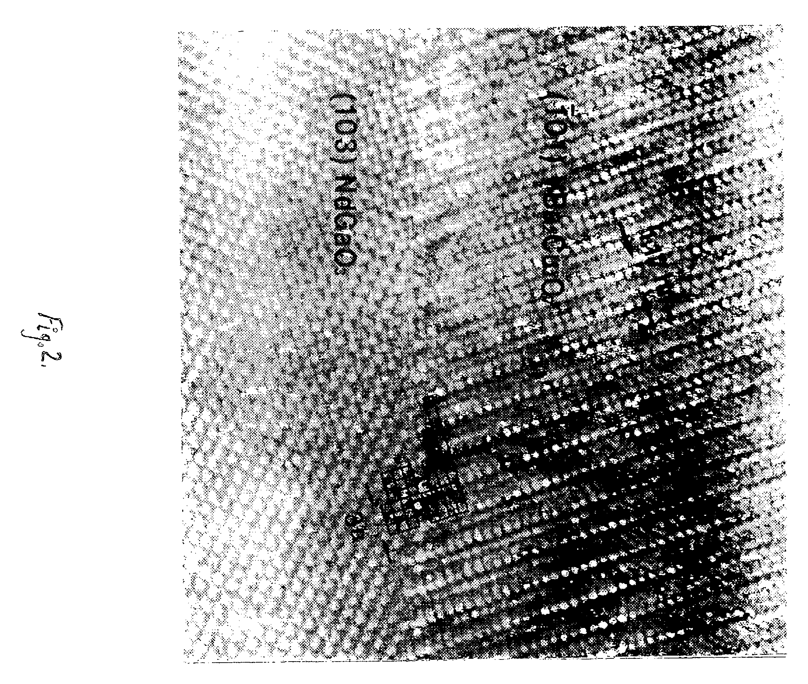

Die elektronenmikroskopischen Querschnittsaufnahme in Figur 2 zeigt einen ($\bar{1}$01)-orientierten $YBa_2Cu_3O_7$-Dünnfilm auf einem (103)-$NaGaO_3$-Substrat (in pseudokubischer Notation). Die hochauflösende transmissionselektronenmikroskopische Aufnahme läßt die Schichtstruktur auf atomarer Skala erkennen; die $CuO_2$-Ebenen sind um einen Winkel von etwa 72° gegenüber der Substratoberflächennormale verkippt.

Der gezeigte Dünnfilm wurde durch DC-Sauerstoff-Hochdrucksputtern bei einer relativ hohen Substrattemperatur im Bereich von beispielsweise 780-800 °C und einer niedrigen Depositionsrate von etwa 100 nm/h hergestellt, weil dies Herstellungsbedingungen sind, welche näher am Gleichgewicht liegen als solche bei schnellerer Deposition oder bei niedrigen Temperaturen. Diese Substrattemperatur wird auch bevorzugt, um beim Depositionsverfahren ein epitaktisches Wachstum von c-Achsenorientierten $YBa_2Cu_3O_{7-x}$-Filmen hoher Qualität auf unverkippten, kubischen (001)-Substraten zu erhalten.

Es wurde bei der Erfindung erkannt, daß für ein pseudokubisches (103)-$NdGaO_3$-Substrat die Orientierung des deponierten Films nicht (109) ist, wie man es ohne die oben erörterten, energetischen Betrachtungen erwarten würde, sondern die $(\bar{1}01)$-Orientierung mit einer starken Verkippung der $CuO_2$-Schichten. Der Film zeigt in vorteilhafter Weise eine einheitliche Ausrichtung ohne Bereiche mit komplementären (109)-Domänen, die nachteilig störende Korngrenzen erzeugen würden. Die Schichtebenen (a,b-Ebenen) des gesputterten Materials sind alle um 71,6° gegenüber der Substratoberfläche verkippt, was dazu führt, daß alle Ebenen die Filmoberfläche erreichen.

Die hohe Qualität der $(\bar{1}01)$-orientierten Filme wird in ihren elektrischen Transporteigenschaften widergespiegelt. In den Figuren 3 und 4 ist die Anisotropie des spezifischen Widerstands sowie der kritischen Stromlichte der Filme in Abhängigkeit von verschiedenen Verkippungswinkeln des Substrats gegenüber der pseudokubischen (001) Orientierung des Substrats gezeigt. Hierbei sind die verschiedenen Substratorientierungen (in pseuiokubischer Notation) mit unterschiedlichen Symbolen gekennzeichnet. Die Verkippung des Substrats ist dabei im die ⟨010⟩-Richtung durchgeführt.

Im einzelnen ist in der Figur 3 der spezifischer Widerstand eines $YBa_2Cu_3O_{7-x}$-Dünnfilms auf $NdGaO_3$-Substraten nit unterschiedlicher Verkippung gezeigt und zwar in Figur 3a entlang der ⟨010⟩-Richtung des Substrats und in Figur 3b senkrecht zur ⟨010⟩-Richtung des Substrats.

Die jeweilige Substratorientierung ist in pseudokubischer Notation angegeben. Nur die Meßkurve auf dem (103)-orientierten Substrat zeigt wegen der $(\bar{1}01)$-Orientierung des aufgewachsenen Dünnfilms ein außergewöhnliches Verhalten, welches nicht monoton von der Substratverkippung abhängt. Für die Verkippungswinkel $\alpha$ der verschiedenen Substratorientierungen gilt hierbei:

$$\alpha_{(001)} \approx 0°, \ \alpha_{(1\,0\,11)} \approx 5°, \ \alpha_{(105)} \approx 10°,$$
$$\alpha_{(103)} \approx 18°, \ \alpha_{(305)} \approx 30°, \ \alpha_{(101)} \approx 45°$$

Im einzelnen ist in der Figur 4 die kritische Stromdichte eines $YBa_2Cu_3O_{7-x}$-Dünnfilms auf $NdGaO_3$-Substraten mit unterschiedlicher Verkippung gezeigt und zwar in Figur 4a entlang der ⟨010⟩-Richtung des Substrats und in Figur 4b senkrecht zur ⟨010⟩-Richtung des Substrats.

Die jeweilige Substratorientierung ist in pseudokubischer Notation angegeben. Nur die Meßkurve auf dem (103)-orientierten Substrat zeigt wegen der $(\bar{1}01)$-Orientierung des aufgewachsenen Dünnfilms ein außergewöhnliches Verhalten, welches nicht monoton von der Substratverkippung abhängt. Für die Verkippungswinkel $\alpha$ der verschiedenen Substratorientierungen gilt hierbei:

$$\alpha_{(001)} \approx 0°, \ \alpha_{(1\,0\,11)} \approx 5°, \ \alpha_{(105)} \approx 10°,$$
$$\alpha_{(103)} \approx 18°, \ \alpha_{(305)} \approx 30°, \ \alpha_{(101)} \approx 45°$$

Die in diesen Figuren dargestellten Meßwerte zeigen im Ergebnis, daß für einen Film mit $(\bar{1}01)$-Orientierung entsprechend der (103)-Orientierung des Substrats die Transporteigenschaften entlang der leitenden $CuO_2$-Ebenen sich kaum von denen eines unverkippten Substrates (0°) mit (001)-Orientierung unterscheiden.

Dieses singuläre Verhalten bei der (103)-Orientierung des Substrats hebt sich deutlich von dem sonstigen Trend einer monotonen Verschlechterung der Transporteigenschaften entlang der leitenden Ebenen mit steigendem Verkippungswinkel des Substrats ab. Es wurde mit Hilfe einer Analyse erkannt, daß dies auf das zunehmende Auftreten von Korngrenzen zwischen den komplementär orientierten Domänen bzw. Antidomänen im Dünnfilm zurückzuführen ist, welches nur bei der (103)-Substratorientierung unterbunden ist.

Erfindungsgemäß soll ein epitaktischer Dünnfilm mit einer Schichtstruktur bereitgestellt werden, derart, daß er eine einheitliche Domänenstruktur (d.h. ohne Korngrenzen zwischen unterschiedlich orientierten Domänen) aufweist und die Orientierung der Schichtebenen innerhalb der Domänen derart ist, daß die kristallographische Richtung senkrecht zu den Schichten um einen Winkel größer als 45° gegenüber der Substratoberflächennormale verkippt ist. Hierbei soll ein annähernd rationales Verhältnis zwischen den Gitterkonstanten $a_{Film}$, $b_{Film}$ innerhalb der Schichtebenen zu der Gitterkonstanten $c_{Film}$ des Films senkrecht zu den Schichtebenen bestehen, d.h. $c_{Film} \approx N \times a_{Film}$ (N = 2,3,4..).

Ein annähernd rationales Verhältnis der Gitterkonstanten bedeutet, daß die Abweichung nicht mehr als 5% beträgt, d.h. für $c_{Film} \approx N \times a_{Film}$ mit N = 2,3,4 ... ; $c_{Film} = n \times a_{Film} = (N \pm dN) \times a_{Film}$, dabei sei N der benachbarte ganzzahlige Wert von n und $dN/N \leq 0,05$ (weniger als 5% Abweichung).

Das Schichtmaterial besitze eine annähernd tetragonale Struktur.

Annähernd tetragonale Struktur des Schichtmaterials möge bedeuten, daß die Gitterkonstanten $a_{Film}$ und $b_{Film}$ in der Schichtebene sich um weniger als 5% unterscheiden, d.h.

$$\left| \frac{a_{Film} - b_{Film}}{a_{Film}} \right| \leq 0,05.$$

Die Winkelabweichung von der Orthogonalität zwischen den Kristallachsen $a_{Film}$, $b_{Film}$, und $c_{Film}$ nicht mehr als 2° beträgt:

$$88° \leq (a_{Film}, b_{Film}) \leq 92°$$

$$88° \leq (a_{Film}, c_{Film}) \leq 92°$$

$$88° \leq (b_{Film}, c_{Film}) \leq 92°$$

Das Substratmaterial mit einer kubischen bzw. pseudokubischen Kristallstruktur mit der Gitterkonstante $a_{Substrat}$ soll dabei für die Filmdeposition mit einer Orientierung aus der Familie {1 0 K×N} mit K = 1,2,.... gewählt werden.

Annähernd kubische (pseudokubische) Struktur des Substrats möge bedeuten, daß die Gitterkonstanten $a_{Substrat}$, $b_{Substrat}$ und $c_{Substrat}$ sich um weniger als 5% unterscheiden, d.h.

$$\max \left\{ \left| \frac{a_{Substrat} - b_{Substrat}}{a_{Substrat}} \right|, \left| \frac{a_{Substrat} - c_{Substrat}}{a_{Substrat}} \right|, \right.$$
$$\left| \frac{b_{Substrat} - c_{Substrat}}{b_{Substrat}} \right|, \left| \frac{a_{Substrat} - b_{Substrat}}{b_{Substrat}} \right|$$
$$\left. \left| \frac{a_{Substrat} - c_{Substrat}}{c_{Substrat}} \right|, \left| \frac{a_{Substrat} - c_{Substrat}}{c_{Substrat}} \right| \right\} \leq 0,05$$

und daß die Winkelabweichung von der Orthogonalität (90°) zwischen den Kristallachsen $a_{Substrat}$, $b_{Substrat}$ und $c_{Substrat}$ nicht mehr als 2° beträgt.

Die Gitterfehlpassung zwischen Film und Substrat sollte gering sein, d.h. $a_{Substrat} \approx a_{Film} \approx b_{Film}$.

Geringe Gitterfehlpassung zwischen Dünnfilm und Substrat möge bedeuten, daß die Abweichung weniger als 5% beträgt, d.h.

$$\left| \frac{a_{Film} - a_{Substrat}}{a_{Substrat}} \right| < 0.05.$$

Der Film mit dieser Struktur wird in dem Fall mit der Orientierung ($\bar{K}$ 01), wobei K = 1,2,... , aufwachsen. Der Fall K = 1 wird dabei für praktische Anwendungen vorrangig von Bedeutung sein und die gewünschten Merkmale aufweisen.

Die Abscheidungsbedingungen für das Schichtmaterial sind nach Möglichkeit dabei so zu wählen, daß sie möglichst Gleichgewichtsbedingungen nahe kommen, d.h. z.B. eine möglichst hohe Substrattemperatur und eine niedrige Abscheiderate.

Es sollen folgende Aspekte der Erfindung mit beinhaltet sein:

I. Dünnschichtmaterialien (in absteigender Folge von allgemeinem zu speziellem Material):

a) Schichtstrukturen mit anisotropen Eigenschaften deren nahezu tetragonale Struktur mit denen der Hochtemperatursupraleiter (HTSL) kristallographisch vergleichbar ist.

b) Hochtemperatursupraleiter bzw. Materialien mit Schichtstruktur, die gekennzeichnet sind durch wenigstens eine $CuO_2$-Ebene wie $REBa_2Cu_3O_{7-x}$ (RE = Y, La, Gd, Pr, Nd....) $HgBa_2Ca_{n-1}Cu_nO_y$ $TlBa_2Ca_{n-1}Cu_nOy$ $Tl_2Ba_2Ca_{n-1}Cu_nO_y$ $Bi_2Sr_2Ca_{n-1}Cu_nO_y$ $La_{2-x}M_xCuO_4$ (M = Ca, Ba, Sr...) etc.

c) $YBa_2Cu_3O_{7-x}$ und (RE $Ba_2Cu_3O_{7-x}$)

II. Substrat-Orientierungen (in absteigender Folge von allgemeiner zu spezieller Substratorientierung):

a) (10M) mit M = K x N (N=2,3,4.. und K=1,2,..) für Dünnschichtmaterialien aus Ia), Ib) und Ic)

b) (10N) (K=1), (allgemein eingeschränkt auf K=1) für Dünnschichtmaterialien aus Ia), Ib) und Ic)

c) (103) (N =3) für $YBa_2Cu_3O_{7-x}$ und $REBa_2Cu_3O_{7-x}$ (104) (N =4) für $TlBa_2Ca_2$ $Cu_3O_x$, $HgBa_2Ca_2Cu_3O_x$, $T_{1-\alpha}$ $M^1_\alpha$ $Ba_{2-\beta}Sr_\beta$ $Ca_2Cu_3O_x$, $Hg_{1-\alpha}$ $M^1_\alpha Ba_{2-\beta}Sr_\beta Ca_2Cu_3O_x$ mit $M^1$ =Pr, Bi, Pb, Tl, Hg,...

und andere Materialien der gleichen Struktur.

## Patentansprüche

1. Schichtenfolge mit wenigstens einem epitaktischen, nicht c-Achsen orientierten Hochtemperatursupraleiter (HTSL)-Dünnfilm mit nahezu tetragonaler Kristallstruktur und mit einem annähernd ganzzahligen Verhältnis der Gitterkonstanten N= c/a > 1, wobei ein kubisches oder pseudokubisches Substrat mit diesem Dünnfilm verbunden ist, **dadurch gekennzeichnet, daß** der Dünnfilm eine Orientierung ($\bar{K}$ O1) bezüglich der Filmoberfläche aufweist und dabei $\bar{K}$ (=-K) einen Wert aus der Menge K = 1, 2, ... annimmt.

2. Schichtenfolge mit wenigstens einer epitaktischen, nicht c-Achsen orientierten Schicht, wobei diese Schicht eine annähernd tetragonale Kristallstruktur ähnlich der eines Hochtemperatursupraleiters (HTSL) und ein annähernd ganzzahliges Verhältnis der Gitterkonstanten N= c/a > 1 aufweist und mit einem kubischen oder pseudokubischen Substrat verbunden ist, **dadurch gekennzeichnet, daß** die Schicht eine Orientierung ($\bar{K}$ O1) bezüglich der Filmoberfläche aufweist und dabei $\bar{K}$ (= -K) einen Wert aus der Menge K = 1, 2, ... annimmt.

3. Schichtenfolge nach Anspruch 1 oder 2, **dadurch gekennzeichnet, daß** der HTSL-Dünnfilm nahezu a-Achsen orientiert oder b-Achsen orientiert ausgebildet ist.

## Claims

1. A layer sequence comprising at least one epitaxial, non-c-axis oriented, high temperature superconductor (HTSC) thin film, which has a near-tetragonal crystal structure and an approximately integral ratio of lattice constants N= c/a > 1, wherein a cubic or pseudo-cubic substrate is associated with said thin film,
characterised in that
the thin film has an orientation ($\bar{K}$01) with respect to the film surface and $\bar{K}$ (= -K) at the same time assumes a value from the set K = 1, 2, ... .

2. A layer sequence comprising at least one epitaxial, non-c-axis oriented layer, wherein said layer has an approximately tetragonal crystal structure similar to that of a high temperature superconductor (HTSC), has an approximately integral ratio of lattice constants N= c/a > 1, and is associated with a cubic or pseudo-cubic substrate,
characterised in that
the layer has an orientation ($\bar{K}$01) with respect to the film surface and $\bar{K}$ (= -K) at the same time assumes a value from the set K = 1, 2, ... .

3. A layer sequence according to claims 1 or 2, characterised in that the HTSC thin film is formed almost a-axis oriented or b-axis oriented.

## Revendications

1. Succession de couches, comportant au moins une couche mince épitaxiale d'un supraconducteur à haute température (HTSL), non-orienté selon l'axe c, ayant une structure cristalline quasi-quadratique, et présentant un rapport approximativement entier entre les constantes de réseau N = c/a > 1, un substrat cubique ou pseudocubique étant assemblé à cette couche mince, caractérisée en ce que la couche mince présente une orientation ($\bar{K}$01) par rapport à la surface de la couche, $\bar{K}$ (= -K) prenant une valeur choisie dans l'ensemble K = 1, 2, ...

2. Séquence de couches comportant au moins une couche épitactique, non-orientée selon l'axe c, cette couche ayant une structure cristalline quasi-quadratique, analogue à celle d'un supraconducteur à haute température (HTSL), et présentant un rapport approximativement entier entre les constantes de réseau N = c/a > 1, et étant assemblée à un substrat cubique ou pseudocubique, caractérisée en ce que la couche présente une orientation ($\bar{K}$01) par rapport à la surface de la couche, et $\bar{K}$ (= -K) prend une valeur choisie dans l'ensemble K = 1, 2, ...

3. Séquence de couches selon la revendication 1 ou 2, caractérisée en ce que la couche mince de HTSL est constituée de façon à être orientée presque selon l'axe a ou selon l'axe b.

(a)

(001) thin film

(001) substrate

(b)

(109) thin film with
antiphase boundaries

(103) substrate

(c)

($\overline{1}$01) thin film

(103) substrate

FIG. 1

Fig. 2.

Fig.4